# EUROPÄISCHE PATENTSCHRIFT

(11) **EP 1 187 330 B1**
(45) Veröffentlichungstag und Bekanntmachung des Hinweises auf die Patenterteilung: **26.09.2007**
(21) Anmeldenummer: 01440236.6
(22) Anmeldetag: 25.07.2001
(51) Int. Cl.: H03K 5/08, H03K 5/125

(54) **Spannungskomparatorschaltung für die Einhüllende einer Wechselspannung und Verfahren dazu**
Voltage comparator circuit for the envelope of an AC voltage and method of comparing
Comparateur de tension pour l'enveloppe d'une tension alternative et méthode de comparaison

(30) Priorität: 29.08.2000 DE 10042270
(43) Veröffentlichungstag der Anmeldung: 13.03.2002
(73) Patentinhaber: Alcatel Transport Solutions Holding GmbH, 70435 Stuttgart (DE)
(72) Erfinder: Altermann, Robert, 2020 Hollabrunn (AT)
(74) Vertreter: Kohler Schmid Möbus

(56) Entgegenhaltungen:
- WO-A-98/19172
- DE-C- 3 718 305
- DE-T- 69 220 851

## Beschreibung

Die Erfindung betrifft ein Verfahren zur Feststellung des Über- oder Unterschreitens der Einhüllenden einer Wechselspannung einer Schwellenspannung mittels einer Spannungskomparatorschaltung und eine Spannungskomparatorschaltung für die Einhüllende einer Wechselspannung mit drei parallel geschalteten Komparatoren, an die die Wechselspannung angelegt ist.

Eine derartige Spannungskomparatorschaltung ist aus der DE 692 20 851 T2 bekannt geworden.

Zur Feststellung, ob die Einhüllende einer Wechselspannung einen Schwellwert über- oder unterschreitet, ist es bekannt, die Einhüllende mittels eines Tiefpassfilters und nachgeschaltetem Komparator mit Hysterese zu ermitteln. Allerdings muss der Tiefpassfilter auf die maximale zeitliche Dynamik des zeitlichen Verlaufs der Einhüllenden angepasst werden. Die Einstellung ist festgelegt und kann nicht automatisch auf sich ändernde dynamische Bedingungen adaptiert werden. Die maximale Frequenz der Einhüllenden und der Wechselspannung dürfen wegen der steilflankigen Übertragungscharakteristik des Filters und der damit verbundenen langen Filtereinschwingzeiten nicht nahe beieinander liegen.

Ferner ist es möglich, die Wechselspannung abzutasten und rechentechnisch zu erfassen. Dies erfordert aber einen hohen Schaltungsaufwand und erlaubt nur eine geringe Maximalfrequenz der Wechselspannung.

Die Spannungskomparatorschaltung der DE 692 20 851 T2 weist einen ersten Komparator zum Vergleich eines Eingabesignals mit einem Referenzsignal und einen zweiten Komparator zur Feststellung, wann das Eingabesignal den Nullpunkt übersteigt auf. Eine Differenzierschaltung, die ein differenziertes Signal eines Eingabesignals erzeugt und eine Teilerschaltung, die die Ausgabe einer Schaltung zum Halten eines Signalspitzenwertes so teilt, dass ein Referenzsignal erzeugt wird, sind vorgesehen. Weiterhin ist ein D-Flip-Flop mit nur einem einzigen Dateneingang vorgesehen, wobei der S-Eingang und der Dateneingang direkt mit einer Spannungsquelle verbunden sind, während der R-Eingang ebenso wie der Taktimpulseingang über Widerstände mit der Spannungsquelle verbunden sind und wobei der Ausgang des Flip-Flops über einen Widerstand, der einen hohen Widerstandswert aufweist, um beim inversen Betrieb des Flip-Flops eine Hysteresecharakteristik zu erreichen, mit dem Eingang eines ersten Komparators verbunden ist.

Allerdings gelingt es mit dieser Schaltung nur, eine Hüllkurve für einen Signalspitzenwert und dessen Lage zu bestimmen. Eine Hysterese für eine Einhüllende einer Wechselspannung wird aber nicht unterstützt.

Aus der DE 36 87 247 T2 ist ein Diversity Empfangs-Funkempfänger mit zwei Empfängern bekannt. Für jeden Empfänger ist ein Hüllwellendetektor zum Erzeugen einer Ausgangsspannung vorgesehen, die der Stärke der durch den Empfänger aufgenommenen elektromagnetischen Signalwelle entspricht. Ein Hysteresevergleicher vergleicht die Ausgaben der beiden Hüllwellendetektoren und erzeugt ein Schaltsteuersignal. Als Reaktion auf das Schaltsignal trifft eine Schalteinrichtung eine Auswahl zwischen den vom ersten und zweiten Empfänger erzeugten Signalen. Die Größe der Hysterese im Vergleicher ist so einstellbar, dass kein oder nur ein minimales Pendeln zwischen den Ausgaben der beiden Empfänger auftritt. Hier bezieht sich die Hysterese auf den Vergleich zweier Einhüllenden und nicht auf das Über- oder Unterschreiten eines Schwellwerts durch die Einhüllende aufgrund von überlagerten Störspannungen.

Aus der DE 37 18 305 C1 ist eine Schaltung zur Pegelüberwachung von Wechselspannungssignalen bekannt geworden, die bei unterhalb eines vorbestimmten Pegelgrenzwertes liegenden Pegelspitzen des Wechselspannungssignals an einem Digitalausgang ein erstes Potential und bei einem Pegelgrenzwert überschreitenden Pegelspitzen ein zweites Potential liefert. Insbesondere hat ein Ausgangssignal zunächst den logischen Pegel "Low". Sobald eine Wechselspannung eine untere Spannungsschwelle überschreitet, wechselt das Ausgangssignal in einen logischen Pegel "High". Dieser Pegel wird beibehalten, bis das Eingangssignal unter die untere Spannungsschwelle absinkt.

Aufgabe der vorliegenden Erfindung ist es daher, eine Spannungskomparatorschaltung der eingangs genannten Art derart weiterzubilden und ein Verfahren zu entwickeln, so dass das Über- oder Unterschreiten der Einhüllenden einer Wechselspannung einer Schwellenspannung festgestellt werden kann, wobei eine Hysterese zur Beseitigung der Wirkung von überlagerten Störspannungen angewandt werden soll.

Gelöst wird diese Aufgabe erfindungsgemäß durch ein Verfahren mit den Merkmalen des Anspruchs 1.

Dieses Verfahren hat den Vorteil, dass sich Störungen z.B. bei Ein- und Ausschwingvorgängen der Wechselspannung nicht sofort im ersten Ausgangssignal bemerkbar machen. Kleine Störungen werden also toleriert, so dass nicht sofort bei einer geringen Veränderung der Einhüllenden der Wechselspannung eine Änderung des Pegels des ersten Ausgangssignals eintritt. Das erste Ausgangssignal weist also eine Hysteresecharakteristik auf. Weiterhin kann das erfindungsgemäße Verfahren durch eine einfache Schaltung implementiert werden.

Eine Verfahrensvariante zeichnet sich dadurch aus, dass ein zweites Ausgangssignal den Pegel "High" einnimmt, wenn das erste Ausgangssignal den Pegel "High" aufweist und die Wechselspannung größer als die vierte Schwellenspannung U₁ ist. Das zweite Ausgangssignal stellt einen geschalteten Takt dar, der nur zur Verfügung steht, wenn das erste Ausgangssignal den Pegel "High" aufweist. Dieser geschaltete Takt kann für nachgeschaltete Schaltungen verwendet werden.

Die Aufgabe der vorliegenden Erfindung wird erfindungsgemäß auch durch eine Spannungskomparatorschaltung, mit den Merkmalen des Anspruchs 3 gelöst.

Die erfindungsgemäße Spannungskomparatorschaltung weist keine frequenzbestimmende Teile wie z.B. Filter auf. Deshalb besteht keine Einschränkung der zeitlichen Dynamik, d.h. die Spannungskomparatorschaltung ist unabhängig von der Frequenz der Wechselspannung und der zeitlichen Dynamik der Einhüllenden. Des Weiteren muss die maximale Frequenz der Einhüllenden nicht wesentlich kleiner sein als die Frequenz der Wechselspannung. Ein weiterer Vorteil ist, dass die Schaltung extrem einfach aufgebaut ist.

Ist der Betrag der ersten Schwellenspannung größer ist als der Betrag der vierten Schwellenspannung und der Betrag der vierten Schwellenspannung größer ist als der Betrag der zweiten oder dritten Schwellenspannung, so nimmt das erste Ausgangssignal den Pegel "High" erst ein, wenn die größte Schwellenspannung durch die Wechselspannung erreicht wird. Der Pegel "Low" stellt sich aber nicht schon deshalb ein, weil die höchste Schwellenspannung, z.B. wegen auftretender Störspannungen, während einer Schwingung nicht erreicht wird, sondern erst, wenn auch die zweitgrößte Schwellenspannung während einer Schwingung nicht erreicht wird.

Bei einer bevorzugten Ausführungsform der Spannungskomparatorschaltung liegt die zweite Schwellenspannung unterhalb und die dritte Schwellenspannung oberhalb des Mittelwerts der Wechselspannung. Durch diese Wahl der zweiten und dritten Schwellenspannungen können die Schwingungen der Wechselspannung detektiert werden.

Bei einer besonders vorteilhaften Ausführungsform sind die erste, dritte und vierte Schwellenspannung positiv. Für die Bewertung der Wechselspannung ist im wesentlichen die positive Halbwelle der Wechselspannung ausreichend. Wird innerhalb einer positiven Halbwelle der Wechselspannung die vierte Spannungsschwelle nicht erreicht, so kann das erste Ausgangssignal sofort auf den Pegel "Low" geschaltet werden.

Besonders vorteilhaft ist es, wenn für jeden Komparator ein Rückkopplungswiderstand vorgesehen ist. Durch diesen Rückkopplungswiderstand kann die Hysterese eingestellt werden. Insbesondere für den ersten Komparator ist der Rückkopplungswiderstand wichtig, da dadurch die Schwellenspannungen des ersten Komparators eingestellt werden können.

Ist die Differenz der Beträge der zweiten und dritten Schwellenspannung größer als die Störspannungen, so können die Schwingungen der Wechselspannung fehlerfrei erkannt werden.

Wenn die Differenz der Beträge der ersten und vierten Schwellenspannung größer als die Störspannungen ist, ist ein fehlerfreies Schalten der Spannungskomparatorschaltung sicher gestellt.

Bei einer vorteilhaften Ausführungsform der erfindungsgemäßen Spannungskomparatorschaltung ist ein zweites Ausgangssignal vorgesehen, das den Pegel "High" annimmt, wenn das erste Ausgangssignal den Pegel "High" hat und die Wechselspannung größer als die vierte Schwellenspannung U₁ ist. Dadurch wird nachfolgenden Schaltungen ein geschalteter Takt zur Verfügung gestellt.

Eine besonders bevorzugte Ausführungsform zeichnet sich dadurch aus, dass ein breitbandiger Vollweggleichrichter vorgesehen ist. Durch die Gleichrichtung der Wechselspannung kann die Detektion der Position der Einhüllenden ober- oder unterhalb einer Schwellenspannung beschleunigt werden. Die zweite und dritte Schwellenspannungen sind bei Verwendung eines Vollweggleichrichters entsprechend anzupassen, d.h. ober- und unterhalb des Mittelwerts der gleichgerichteten Spannung zu wählen.

Die den Komparatoren nachgeschaltete Auswerteschaltung kann besonders einfach gestaltet werden, wenn sie ein D-Flip-Flop, zwei RS-Flip-Flops und ein JK-Flip-Flop umfasst.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen naher erläutert. Es zeigen:
- Fig. 1: ein Blockschaltbild der erfindungsgemäßen Spannungskomparatorschaltung;
- Fig. 2: ein schematisches Zustandsdiagramm zur Erläuterung der Funktionsweise der Spannungskomparatorschaltung; und
- Fig. 3: eine Wechselspannung, Ausgangssignale der Komparatoren und Ausgangssignale der Spannungskomparatorschaltung.

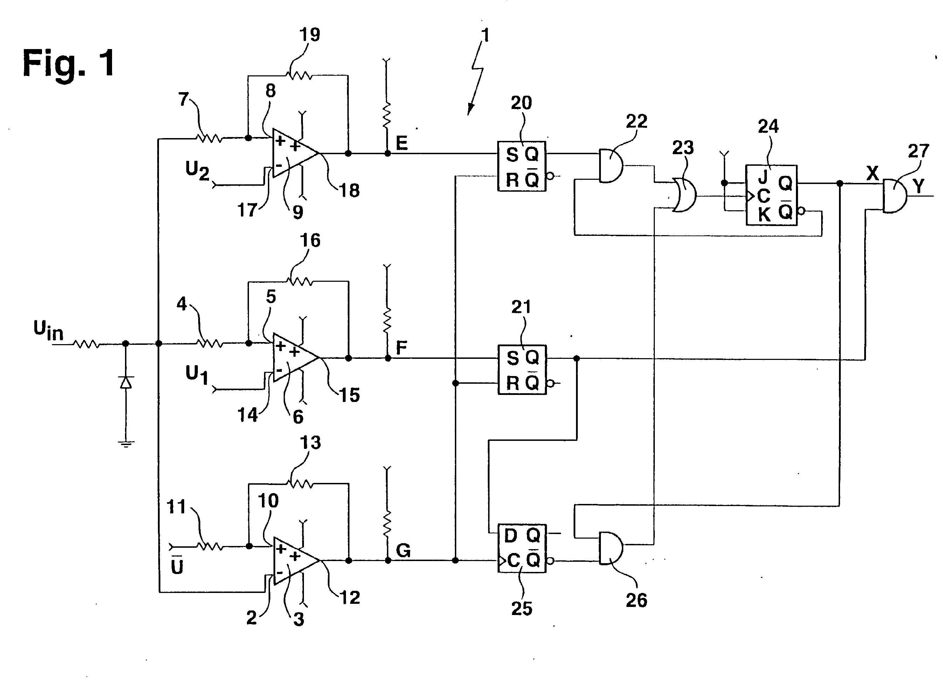

**Fig. 1** zeigt ein Blockschaltbild **1** der erfindungsgemäßen Spannungskomparatorschaltung. Eine Wechselspannung **Uᵢₙ** liegt am negativen Eingang **2** eines ersten Komparators **3**, über einen Widerstand **4** am positiven Eingang **5** eines zweiten Komparators **6** und über einen Widerstand **7** am positiven Eingang **8** eines dritten Komparators **9** an. Am positiven Eingang **10** des ersten Komparators **3** liegt über einen Widerstand **11** der Mittelwert der Wechselspannung U̅ an. Der Ausgang **12** des ersten Komparators 3 ist über einen Widerstand **13** auf den positiven Eingang 10 rückgekoppelt. Dies bewirkt eine Hysterese des Ausgangssignals **G** des ersten Komparators 3. Das bedeutet, dass das Signal G bei Erreichen der Wechselspannung Uᵢₙ einer Schwellenspannung U₀ₐ einen positiven Wert annimmt und diesen Wert hält, bis die Wechselspannung Uᵢₙ eine Schwellenspannung U_{0b} erreicht. Das Signal G nimmt zu diesem Zeitpunkt einen negativen Wert an und behält diesen Wert. Die Schwellenspannungen U₀ₐ und U_{0b} werden über die Widerstände 11,13 eingestellt.

Am negativen Eingang **14** des zweiten Komparators 6 liegt eine , Schwellenspannung **U₁** an. Der Ausgang **15** des zweiten Komparators 6 ist über einen Widerstand **16** auf den positiven Eingang 5 des zweiten Komparators 6 rückgekoppelt. Das Ausgangssignal **F** des zweiten Komparators 6 nimmt positive Werte an, solange die Wechselspannung Uᵢₙ größer ist als die Schwellenspannung U₁ und negative Werte, solange sie kleiner als U₁ ist.

Am negativen Eingang **17** des dritten Komparators 9 liegt eine Schwellenspannung **U₂** an. Der Ausgang **18** des dritten Komparators 9 ist über einen Widerstand **19** auf den positiven Eingang 8 des dritten Komparators 9 rückgekoppelt. Das Ausgangssignal **E** des dritten Komparators nimmt positive Werte an, solange die Wechselspannung Uᵢₙ größer ist als die Schwellenspannung U₂ und negative Werte, solange sie kleiner als U₂ ist.

Der Ausgang 18 des dritten Komparators 9 ist mit dem S-Eingang eines RS-Flip-Flops **20** verbunden. Der R-Eingang des RS-Flip-Flops 20 ist mit dem Ausgang 12 des ersten Komparators 3 verbunden.

Der Ausgang 15 des zweiten Komparators 6 ist mit dem S-Eingang eines RS-Flip-Flops **21** verbunden. Der R-Eingang des RS-Flip-Flops 21 ist mit dem Ausgang 12 des ersten Komparators 3 verbunden.

Das RS-Flip-Flop 20 ist mit seinem Q-Ausgang mit einem AND-Gatter **22** verbunden. Der Ausgang des AND-Gatters 22 ist mit dem einen Eingang eines OR-Gatters **23** verbunden und der Ausgang des OR-Gatters 23 ist mit dem Takteingang eines JK-Flip-Flops **24** verbunden. Das Ausgangssignal des OR-Gatters 23 wirkt also als Taktsignal des JK-Flip-Flops 24. Beide Steuereingänge des JK-Flip-Flops 24 sind mit einer Spannungsquelle **25** verbunden und sind somit permanent auf einem "High"-Pegel. Bei jedem Taktsignal wird daher der Ausgangspegel gewechselt. Der Ausgangspegel am Q-Ausgang des JK-Flip-Flops 24 stellt das erste Ausgangssignal **X** der Spannungskomparatorschaltung 1 dar. Ein Ausgangssignal X "High" bedeutet, dass die Einhüllende der Wechselspannung Uᵢₙ in einem nutzbaren Bereich liegt und keine größeren Störspannungen auftreten. Dadurch, dass der Pegel "High" vom Signal X erst eingenommen wird, wenn die Schwellspannung U₂ überschritten wird und dass erst in den "Low" Zustand geschaltet wird, wenn die Schwellenspannung U₁ nicht mehr erreicht wird, machen sich Störspannungen bei Ein- und Ausschwingvorgängen der Wechselspannung Uᵢₙ nicht sofort im Signal X bemerkbar. Das Signal X weist also eine Hysteresecharakteristik auf. Der Q̅-̅Ausgang des JK-Flip-Flops 24 ist mit dem zweiten Eingang des AND-Gatters 22 verbunden. Der Q-Ausgang des RS-Flip-Flops 21 ist mit dem Steuereingang eines D-Flip-Flops 25 verbunden, welches durch das Signal G getaktet wird. Der Q̅-Ausgang des D-Flip-Flops 25 ist mit einem Eingang eines AND-Gatters **26** verbunden. Der andere Eingang des AND-Gatters 26 ist mit dem Q-Ausgang des JK-Flip-Flops 24 verbunden. Der Ausgang des AND-Gatters 26 ist mit dem Eingang des OR-Gatters 23 verbunden. Der Q-Ausgang des RS-Flip-Flops 21 ist weiterhin mit dem Eingang eines AND-Gatters **27** verbunden. Der andere Eingang des AND-Gatters 27 ist mit dem Q-Ausgang des JK-Flip-Flops 24 verbunden. Das Ausgangssignal des AND-Gatters 27 stellt das zweite Ausgangssignal Y dar. Es nimmt den Pegel "High" an, wenn das Ausgangssignal X den Pegel "High" hat und die Wechselspannung Uᵢₙ größer ist als U₁.

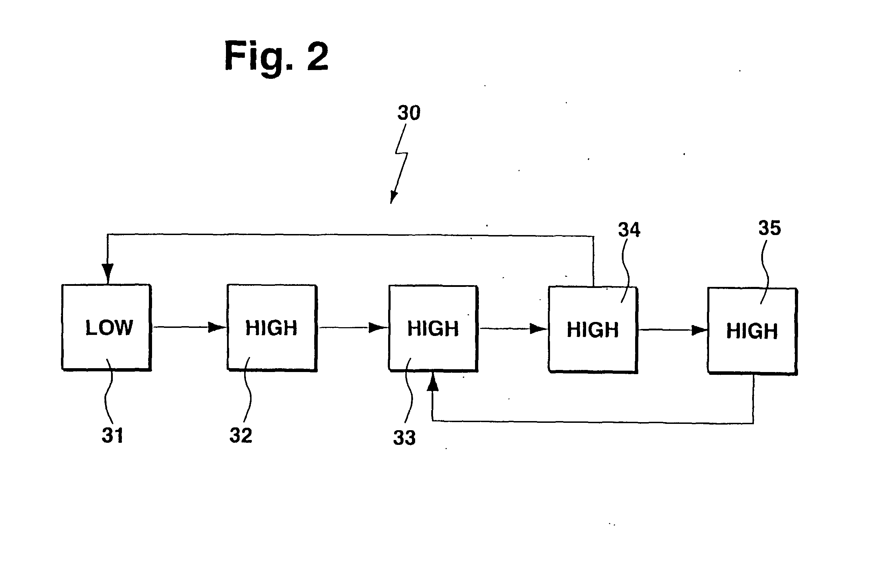

**Fig. 2** zeigt ein schematisches Zustandsdiagramm **30** zur Erläuterung der Funktionsweise der Spannungskomparatorschaltung 1. Im Ausgangszustand **31** der Spannungskomparatorschaltung **1** nimmt das erste Ausgangssignal X den Pegel "Low" an. Sobald die positive Halbwelle der Wechselspannung Uᵢₙ die Schwellenspannung U₂ überschreitet, geht die Spannungskomparatorschalung in den Zustand **32** und das Ausgangssignal X nimmt den Pegel "High" an. Das bedeutet, dass die Einhüllende der Wechselspannung Uᵢₙ größer ist als eine vorgegeben Schwellenspannung U₂. Wird die Wechselspannung Uᵢₙ gegen Ende der positiven Halbwelle kleiner als die Schwellenspannung U₀ₐ, welche unterhalb des Mittelwertes U̅ der Wechselspannung Uᵢₙ gewählt wird, so nimmt die Spannungskomparatorschaltung **1** den Zustand **33** ein. Das Ausgangssignal X behält den Pegel "High". Nach Durchlaufen der negativen Halbwelle der Wechselspannung Uᵢₙ, durchläuft die Wechselspannung Uᵢₙ die Schwellenspannung U_{0b}, die oberhalb des Mittelwerts U̅ der Wechselspannung Uᵢₙ gewählt wird. Sobald die Wechselspannung Uᵢₙ größer als die Schwellenspannung U_{0b} wird, nimmt die Spannungskomparatorschaltung 1 den Zustand **34** ein. Das Ausgangssignal X behält den Pegel "High" bei. Steigt die Wechselspannung Uᵢₙ weiter bis zur Schwellenspannung U₁, so nimmt die Spannungskomparatorschaltung 1 den Zustand **35** ein. Wird die Schwellenspannung U₁ nicht erreicht und fällt die Wechselspannung Uᵢₙ wieder unter die Schwellenspannung U₀ₐ, so wird der Zustand 31 eingenommen und das Ausgangssignal X nimmt den Pegel "Low" an, was bedeutet, dass eine Störspannung aufgetreten ist und die Einhüllende der Wechselspannung Uᵢₙ nicht länger verwendbar ist. Im Zustand 35 behält das Ausgangssignal X den Pegel "High" bei. Fällt die Wechselspannung Uᵢₙ wieder unter die Schwellenspannung U₀ₐ, so nimmt die Spannungskomparatorschaltung 1 den Zustand 33 ein.

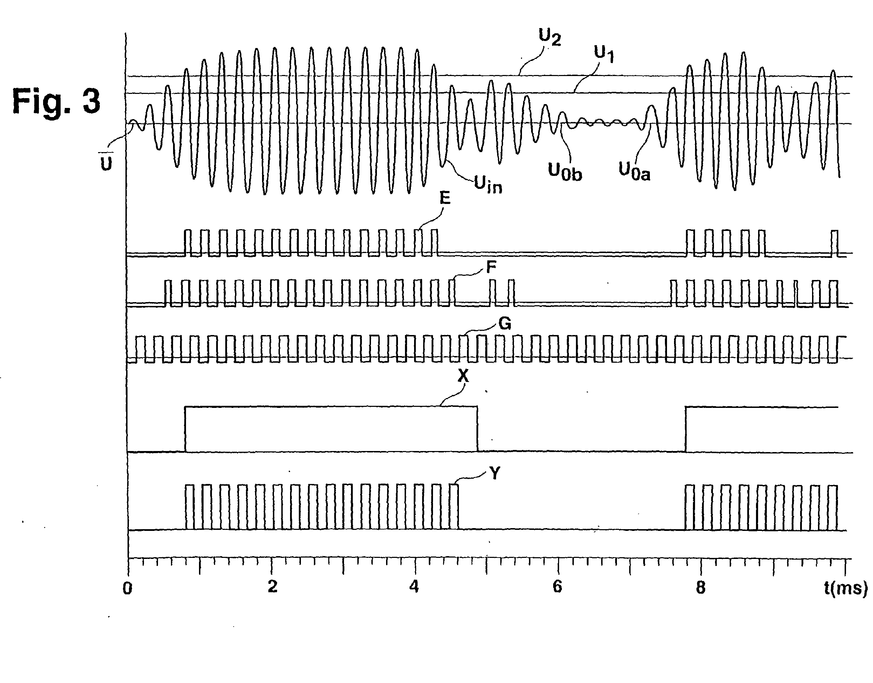

**Fig. 3** zeigt exemplarisch einen zeitlichen Verlauf der Wechselspannung Uᵢₙ, sowie der Ausgangssignale E,F,G der Komparatoren 3,6,9 und der Ausgangssignale X und Y. Die Wechselspannung Uᵢₙ stammt von einem vorgeschalteten steilflankigen Bandpassfilter. Bis zum Zeitpunkt von etwa 1ms liegt ein ungestörter Einschwingvorgang vor. Ab dem Zeitpunkt 4ms erfolgt ein gestörter Ausschwingvorgang, der noch keine Änderung des Ausgangssignals X bewirkt. Bei etwa 5ms tritt eine Störung auf, die eine Änderung des Ausgangssignals X bewirkt. Bei etwa 7ms beginnt erneut ein Einschwingvorgang und bei 9ms tritt wieder ein gestörter Ausschwingvorgang auf. Die Schwellenspannung U₀ₐ und U_{0b} wurden in diesem Beispiel in unmittelbarer Nähe des Mittelwertes U̅ von 0V gelegt. Die Auflösung der Darstellung ist nicht ausreichend, um zwischen U̅, U₀ₐ und U_{0b} zu unterscheiden. Die Schwellenspannungen U₁ und U₂ der Komparatoren 6,9 sind durch horizontale Linien dargestellt.

Das Signal E des Komparators 9 nimmt einen positiven Wert an, sobald die Wechselspannung Uᵢₙ die Schwellenspannung U₂ überschreitet. Dieser positive Wert wird gehalten, bis die Wechselspannung Uᵢₙ wieder unter die Schwellenspannung U₂ fällt. Beim Komparator 9 handelt es sich um einen Komparator mit Hysterese. Damit wird bewirkt, dass die erzeugten Impulse nicht zu kurz sind, so dass sie von der Auswertelogik auch detektiert werden können. Wenn die Wechselspannung Uᵢₙ kleiner als die Schwellenspannung U₂ ist, nimmt das Signal E einen negativen Wert an.

Das Signal F des Komparators 6 nimmt einen positiven Wert an, sobald die Wechselspannung Uᵢₙ die Schwellenspannung U₁ überschreitet. Dieser positive Wert wird gehalten, bis die Wechselspannung Uᵢₙ wieder unter die Schwellenspannung U₁ fällt. Wenn die Wechselspannung Uᵢₙ kleiner als die Schwellenspannung U₁ ist, nimmt das Signal F einen negativen Wert an. Der Komparator 6 weist eine Hysterese auf.

Das Signal G nimmt einen positiven Wert an, wenn die Wechselspannung Uᵢₙ unter die Schwellenspannung U₀ₐ fällt und nimmt einen negativen Wert an, wenn die Wechselspannung Uᵢₙ größer als die Schwellenspannung U_{0b} wird.

Das Ausgangssignal X der Spannungskomparatorschaltung hat zu Begin den Pegel "Low". Der Pegel "High" wird eingenommen, sobald die Wechselspannung Uᵢₙ zum ersten Mal die Schwellenspannung U₂ überschreitet.

Der Pegel "Low" wird wieder eingenommen, wenn die Wechselspannung Uᵢₙ nach Durchlaufen der Schwellenspannung U_{0b} die Schwellenspannung U₀ₐ durchläuft, ohne dazwischen die Schwellenspannung U₁ erreicht zu haben. Das Ausgangssignal Y nimmt den Pegel "High" an, wenn das Ausgangssignal X den Pegel "High" hat und das Signal F positiv ist, d.h. die Wechselspannung Uᵢₙ größer als die Schwellenspannung U₁ ist.

## Patentansprüche

1. Verfahren zur Feststellung des Über- oder Unterschreitens der Einhüllenden einer Wechselspannung (Uᵢₙ) einer Schwellenspannung mittels einer Spannungskomparatorschaltung (1),
**dadurch gekennzeichnet,**
**dass** ein erstes Ausgangssignal (X) zu Beginn den Pegel "Low" aufweist und den Pegel "High" einnimmt, sobald die Wechselspannung (Uᵢₙ) eine erste betragsmäßig größte Schwellenspannung (U₂) überschreitet und das Ausgangssignal (X) wieder den Pegel "Low" einnimmt, wenn nach Überschreiten einer zweiten Schwellenspannung (U₀ₐ) unterhalb des Mittelwerts (U̅) der Wechselspannung (Uᵢₙ) eine dritte Schwellenspannung (U_{0b}) oberhalb des Mittelwerts (U̅) durch die Wechselspannung (Uᵢₙ) unterschritten wird, ohne dass zwischenzeitlich eine betragsmäßig zweitgrößte vierte Schwellenspannung (U₁) erreicht wurde, wobei die zweite oder dritte Schwellenspannung (U₀ₐ, U_{0b}) betragsmäßig kleiner sind als die betragsmäßig zweitgrößte vierte Schwellenspannung (U₁).

2. Verfahren nach Anspruch 1, **dadurch gekennzeichnet, dass** ein zweites Ausgangssignal (Y) den Pegel "High" einnimmt, wenn das erste Ausgangssignal (X) den Pegel "High" aufweist und die Wechselspannung (Uᵢₙ) größer als die vierte Schwellenspannung (U₁) ist.

3. Spannungskomparatorschaltung (1) für die Einhüllende einer Wechselspannung (Uᵢₙ), mit drei parallel geschalteten Komparatoren (3,6,9), an die die Wechselspannung (Uᵢₙ) angelegt ist,
**dadurch gekennzeichnet,**
**dass** als Komparatoren (3,6,9) Komparatoren mit Hysterese vorgesehen sind, dass der erste Komparator (3) eine zweite und dritte Schwellenspannung (U₀ₐ,U_{0b}) aufweist, der zweite Komparator (6) eine vierte Schwellenspannung (U₁) aufweist und der dritte Komparator (9) eine erste Schwellenspannung (U₂) aufweist, und dass eine logische Schaltung zur Ermittlung eines Ausgangssignals (X) in Abhängigkeit der Ausgangssignale (G,F,E) der Komparatoren (3,6,9) vorgesehen und derart ausgebildet ist, dass das Ausgangssignal (X) von einem ersten zu einem zweiten logischen Pegel wechselt, sobald die Wechselspannung (Uᵢₙ) die erste Schwellenspannung (U₂) überschreitet und das Ausgangssignal (X) von dem zweiten zu dem ersten logischen Pegel wechselt, wenn die vierte Schwellenspannung (U₁) während einer Schwingung der Wechselspannung (Uᵢₙ) nicht erreicht wird, wobei der Betrag der ersten Schwellenspannung (U₂) größer ist als der Betrag der vierten Schwellenspannung (U₁) und der Betrag der vierten Schwellenspannung (U₁) größer ist als der Betrag der zweiten oder dritten Schwellenspannung (U₀ₐ, U_{0b}).

4. Spannungskomparatorschaltung nach Anspruch 3, **dadurch gekennzeichnet, dass** die zweite Schwellenspannung (U₀ₐ) unterhalb und die dritte Schwellenspannung (U_{0b}) oberhalb des Mittelwerts der Wechselspannung (Uᵢₙ) liegt.

5. Spannungskomparatorschaltung nach einem der Ansprüche 3 oder 4, **dadurch gekennzeichnet, dass** die erste (U₂), dritte (U_{0b}) und vierte (U₁) Schwellenspannungen positiv sind.

6. Spannungskomparatorschaltung nach einem der Ansprüche 3 bis 5, **dadurch gekennzeichnet, dass** für jeden Komparator (3,6,9) ein Rückkopplungswiderstand (13,16,19) vorgesehen ist.

7. Spannungskomparatorschaltung nach einem der Ansprüche 3 bis 6, **dadurch gekennzeichnet, dass** die Differenz der Beträge der zweiten und dritten Schwellenspannung (U₀ₐ, U_{0b}) größer als die Störspannungen ist.

8. Spannungskomparatorschaltung nach einem der Ansprüche 3 bis 7, **dadurch gekennzeichnet, dass** die Differenz der Beträge der ersten und vierten Schwellenspannung (U₂, U₁) größer als die Störspannungen ist.

9. Spannungskomparatorschaltung nach einem der Ansprüche 3 bis 8, **dadurch gekennzeichnet, dass** ein zweites Ausgangssignal (Y) vorgesehen ist, das den Pegel "High" annimmt, wenn das erste Ausgangssignal (X) den Pegel "High" hat und die Wechselspannung (Uᵢₙ) größer als die vierte Schwellenspannung (U₁) ist.

10. Spannungskomparatorschaltung nach einem der Ansprüche 3 bis 9, **dadurch gekennzeichnet, dass** ein Vollweggleichrichter vorgesehen ist.

11. Spannungskomparatorschaltung nach einem der Ansprüche 3 bis 10, **dadurch gekennzeichnet, dass** die logische Schaltung ein D-Flip-Flop, zwei RS-Flip-Flops und ein JK-Flip-Flop umfasst.

## Claims

1. Method to establish that the envelope of an AC voltage (Uᵢₙ) has exceeded or not reached a threshold voltage by means of a voltage comparator circuit (1),
**characterised in that**
a first output signal (X) has the "Low" level at the beginning and takes up the "High" level as soon as the AC voltage (Uᵢₙ) exceeds a first, largest threshold voltage (U₂) according to the amount and the output signal (X) takes up the "Low" level again if, after exceeding a second threshold voltage (U₀ₐ) below the average value (U̅) of the AC voltage (Uᵢₙ), a third threshold voltage (U_{0b}) above the average value (U̅) is not reached by the AC voltage (Uᵢₙ), without a second largest, fourth threshold voltage (Uₐ) according to the amount being reached in the meantime, in which the second or third threshold voltages (U₀ₐ, U_{0b}) are smaller than the second largest, fourth threshold voltage (U₁) according to the amount.

2. Method according to claim 1, **characterised in that** a second output signal (Y) takes up the "High" level, if the first output signal (X) has the "High" level and the AC voltage (Uᵢₙ) is greater than the fourth threshold value (U₁).

3. Voltage comparator circuit (1) for the envelope of an AC voltage (Uᵢₙ) with three comparators (3, 6, 9), to which the AC voltage (Uᵢₙ) is connected in parallel,
**characterised in that**
comparators with hysteresis are provided as comparators (3, 6, 9), the first comparator (3) has a second and third threshold voltage (U₀ₐ, U_{0b}), the second comparator (6) has a fourth threshold voltage (U₁) and the third comparator (9) has a first threshold voltage (U₂) and a logic circuit is provided to identify an output signal (X) depending on the output signals (G, F, E) of the comparators (3, 6, 9) made in such a way that the output signal (X) changes from a first to a second logic level, as soon as the AC voltage (Uᵢₙ) exceeds a first threshold voltage (U₂) and the output signal (X) changes from the second to the first logic level, if the fourth threshold voltage (U₁) is not reached during an oscillation of the AC voltage (Uᵢₙ), in which the amount of the first threshold voltage (U₂) is greater than the amount of the fourth threshold voltage (U₁) and the amount of the fourth threshold voltage (U₁) is greater than the amount of the second or third threshold voltage (U₀ₐ, U_{0b}).

4. Voltage comparator circuit according to claim 3, **characterised in that** the second threshold voltage (U₀ₐ) is below and the third threshold voltage (U_{0b}) is above the average value of the AC voltage (Uᵢₙ).

5. Voltage comparator circuit according to one of claims 3 or 4, **characterised in that** the first (U₂), third (U_{0b}) and fourth (U₁) threshold voltages are positive.

6. Voltage comparator circuit according to one of claims 3 to 5, **characterised in that** a feedback resistance (13, 16, 19) is provided for each comparator (3, 6, 9).

7. Voltage comparator circuit according to one of claims 3 to 6, **characterised in that** the difference in the amounts of the second and third threshold voltages (U₀ₐ, U_{0b}) is greater than the interference voltages.

8. Voltage comparator circuit according to one of claims 3 to 7, **characterised in that** the difference in the amounts of the first and fourth threshold voltages (U₂, U₁) is greater than the interference voltages.

9. Voltage comparator circuit according to one of claims 3 to 8, **characterised in that** a second output signal (Y) is provided, which takes on the "High" level, if the first output signal (X) has the "High" level and the AC voltage (Uᵢₙ) is greater than the fourth threshold voltage (U₁).

10. Voltage comparator circuit according to one of claims 3 to 9, **characterised in that** a full wave rectifier is provided.

11. Voltage comparator circuit according to one of claims 3 to 10, **characterised in that** the logic circuit comprises a D flip flop, two RS flip flops and a JK flip flop.

## Revendications

1. Procédé pour établir le franchissement par l'enveloppe d'une tension alternative (Uᵢₙ) d'une tension seuil au moyen d'un comparateur de tension (1),
**caractérisé en ce que**
un premier signal de sortie (X) présente au début le niveau « bas » et adopte le niveau « élevé », dès que la tension alternative (Uᵢₙ) dépasse une première tension seuil (U₂) qui est la plus grande en valeur et le signal de sortie (X) adopte à nouveau le niveau « bas », lorsque après le dépassement d'une deuxième tension seuil (U₀ₐ) en dessous de la valeur moyenne (U̅) de la tension alternative (Uᵢₙ) une troisième tension seuil (U_{0b}) au-dessus de la valeur moyenne (U̅) reste en dessous de la tension alternative (Uᵢₙ), sans que entre temps une quatrième tension seuil (U₁) qui est la deuxième plus grande en valeur ait été atteinte, où la deuxième ou la troisième tension seuil (U₀ₐ, U_{0b}) sont en valeur inférieures à la quatrième tension seuil (U₁) qui est la deuxième plus grande en valeur.

2. Procédé selon la revendication 1, **caractérisé en ce qu'**un deuxième signal de sortie (Y) adopte le niveau « élevé », lorsque le premier signal de sortie (X) présente le niveau « élevé » et la tension alternative (Uᵢₙ) est plus grande que la quatrième tension seuil (U₁).

3. Comparateur de tension (1) pour l'enveloppe d'une tension alternative (Uᵢₙ) comportant trois comparateurs (3,6,9) branchés en parallèle, auxquels la tension alternative (Uᵢₙ) est appliquée,
**caractérisé en ce que**
comme comparateurs (3,6,9), des comparateurs avec hystérésis sont prévus, **en ce que** le premier comparateur (3) présente une deuxième et une troisième tensions seuils (U₀ₐ,U_{0b}), le deuxième comparateur (6) présente une quatrième tension seuil (U₁) et le troisième comparateur (9) présente une première tension seuil (U₂), et **en ce qu'**un circuit logique pour déterminer un signal de sortie (X) en fonction des signaux de sortie (G,F,E) des comparateurs est prévu et configuré de telle sorte que le signal de sortie (X) varie d'un premier à un deuxième niveaux logiques, dès que la tension alternative (Uᵢₙ) dépasse la première tension seuil (U₂) et le signal de sortie (X) varie du premier au deuxième niveaux logiques, lorsque la quatrième tension seuil (U₁) n'est pas atteinte pendant une oscillation de la tension alternative (Uᵢₙ), la valeur de la première tension seuil (U₂) étant plus grande que la valeur de la quatrième tension seuil (U₁) et la valeur de la quatrième tension seuil (U₁) étant plus grande que la valeur de la deuxième ou la troisième tension seuil (U₀ₐ, U_{0b}).

4. Comparateur de tension selon la revendication 3, **caractérisé en ce que** la deuxième tension seuil (U₀ₐ) est en dessous de la valeur moyenne de la tension alternative (Uᵢₙ) et la troisième tension seuil (U_{0b}) est au-dessus de celle-ci.

5. Comparateur de tension selon une des revendications 3 ou 4, **caractérisé en ce que** la première (U₂), la troisième (U_{0b}) et la quatrième (U₁) tensions seuils sont positives.

6. Comparateur de tension selon une des revendications 3 à 5, **caractérisé en ce que** pour chaque comparateur (3,6,9) une résistance de rétroaction (13,16,19) est prévue.

7. Comparateur de tension selon une des revendications 3 à 6, **caractérisé en ce que** la différence des valeurs de la deuxième et de la troisième tensions seuils (U₀ₐ, U_{0b}) est plus grande que les tensions parasites.

8. Comparateur de tension selon une des revendications 3 à 7, **caractérisé en ce que** la différence des valeurs de la première et de la quatrième tensions seuils (U₂, U₁) est plus grande que les tensions parasites.

9. Comparateur de tension selon une des revendications 3 à 8, **caractérisé en ce qu'**un deuxième signal de sortie (Y) est prévu, lequel adopte le niveau « élevé », lorsque le premier signal de sortie (X) a le niveau « élevé » et la tension alternative (Uᵢₙ) est plus grande que la quatrième tension seuil (U₁).

10. Comparateur de tension selon une des revendications 3 à 9, **caractérisé en ce qu'**un redresseur à double alternance est prévu.

11. Comparateur de tension selon une des revendications 3 à 10, **caractérisé en ce que** le circuit logique comprend une bascule D, deux bascules RS et une bascule JK.
